Europäisches Patentamt

European Patent Office

Office européen des brevets

(19)

(11) Veröffentlichungsnummer: **0 242 626 B1**

(12) **EUROPÄISCHE PATENTSCHRIFT**

(45) Veröffentlichungstag der Patentschrift: **12.06.91**

(51) Int. Cl.⁵: **H01L 23/48**, H01L 21/60

(21) Anmeldenummer: **87104440.0**

(22) Anmeldetag: **25.03.87**

(54) **Verfahren zur Befestigung von elektronischen Bauelementen auf einem Substrat.**

(30) Priorität: **22.04.86 DE 3613572**

(43) Veröffentlichungstag der Anmeldung:
**28.10.87 Patentblatt 87/44**

(45) Bekanntmachung des Hinweises auf die
Patenterteilung:
**12.06.91 Patentblatt 91/24**

(84) Benannte Vertragsstaaten:
**CH DE FR GB IT LI SE**

(56) Entgegenhaltungen:
**DE-A- 3 414 065**
**GB-A- 2 067 117**

(73) Patentinhaber: **Siemens Aktiengesellschaft**
**Wittelsbacherplatz 2**
**W-8000 München 2(DE)**

(72) Erfinder: **Schwarzbauer, Herbert, Dr.**
**Kössener Strasse 13a**
**W-8000 München 70(DE)**

## Beschreibung

Die Erfindung betrifft ein Verfahren zur Befestigung von elektronischen Bauelementen, insbesondere von großflächigen Leistungshalbleitern, auf einem Substrat durch Drucksintern.

Bei der konventionellen Herstellung von großflächigen Leistungshalbleitern wie Thyristoren und dgl. werden zunächst ein Substrat aus Molybdän, ein Plättchen aus Aluminium und ein Halbleiterkörper aus Silizium durch Erwärmen auf etwa 700 - 800°C miteinander verbunden, wobei die Verbindung zwischen Aluminium und Molybdän als eine Art Lötverbindung angesehen werden kann, während die Verbindung zwischen Aluminium und Silizium durch die Bildung einer eutektischen Legierung bewirkt wird. Während dieses Legierungsvorganges erfolgt dabei gleichzeitig eine Dotierung des Siliziums. Die hohe Temperaturbelastung führt durch die unterschiedlichen Wärmeausdehnungskoeffizienten der einzelnen Teile zu hohen Spannungen im Leistungshalbleiter, was sich beim fertigen Produkt durch entsprechende Verwölbungen bemerkbar macht.

Bei der sog. MOS-Technik werden beim Dotieren und bei der Strukturerzeugung durch die Anwendung von Fotolacktechniken und Ätztechniken Genauigkeiten im Bereich von μm ermöglicht. Eine Anwendung der MOS-Technik auf die Herstellung großflächiger Leistungshalbleiter war bislang jedoch nicht möglich, da die für ein Auflegieren auf ein Substrat erforderlichen hohen Temperaturen zu einer Zerstörung der pn-Übergänge und der feinen Aluminiumstrukturen führen würden. Auch eine Herstellung der Strukturen nach dem Auflegieren des Siliziums auf das Substrat wäre nicht möglich, da die vorhandenen Verwölbungen die Anwendung von Fotolacktechniken und Ätztechniken mit Genauigkeiten im Bereich von μm ausschließen würden.

Aus der DE-OS 3 414 065 ist bereits ein Verfahren zur Befestigung von elektronischen Bauelementen auf einem Substrat durch Drucksintern bekannt, bei welchem man

- eine aus Metallpulver, vorzugsweise Silberpulver, und einem Lösungsmittel bestehende Paste schichtförmig auf die Kontaktierungsschicht des Bauelements und/oder die Kontaktoberfläche des Substrats aufträgt,
- dann das Bauelement auf das Substrat aufsetzt,
- das Lösungsmittel vollständig austreibt und
- dann die gesamte Anordnung unter gleichzeitiger Anwendung eines mechanischen Druckes von 80 - 90 N/cm² auf Sintertemperaturen zwischen 380 und 420°C erwärmt.

Bei der Anwendung dieses bekannten Verfahrens konnten insbesondere kleine elektronische Bauelemente bei relativ niedriger Wärmebeanspruchung mit einer hohen mechanischen Festigkeit mit einem Substrat verbunden werden, wobei die durch Drucksintern hergestellten Verbindungsschichten äußerst geringe elektrische Übergangswiderstände und auch sehr kleine Wärmewiderstände aufwiesen. Eine Anwendung des bekannten Verfahrens auf die Befestigung von großflächigen Leistungshalbleitern auf einem Substrat führte jedoch zu keinen brauchbaren Ergebnissen. Die durch Drucksintern hergestellten Verbindungsschichten waren stets inhomogen und von kanalartigen Strukturen durchsetzt, was dementsprechend zu geringen Haftfestigkeiten, hohen elektrischen Übergangswiderständen und hohen Wärmewiderständen führte.

Der Erfindung liegt die Aufgabe zugrunde, ein Verfahren zur Befestigung von elektronischen Bauelementen auf einem Substrat durch Drucksintern zu schaffen, welches auch für großflächige Leistungshalbleiter geeignet ist. Insbesondere sollen auch durch MOS-Technik hergestellte elektronische Bauelemente bei geringer Wärmebelastung auf einem Substrat befestigt werden können.

Diese Aufgabe wird durch ein Verfahren zur Befestigung von elektronischen Bauelementen, insbesondere von großflächigen Leistungshalbleitern, auf einem Substrat durch Drucksintern gelöst, bei welchem man

a. eine aus Metallpulver und einem Lösungsmittel bestehende Paste schichtförmig auf die Kontaktierungsschicht des Bauelements und/oder die Kontaktoberfläche des Substrats aufträgt,

b. dann die aufgetragene Paste trocknet,

c. das Bauelement auf das Substrat aufsetzt und

d. dann die gesamte Anordnung unter gleichzeitiger Ausübung eines mechanischen Druckes von mindetens 900 N/cm² auf Sintertemperatur erwärmt.

Der Erfindung liegt die Erkenntnis zugrunde, daß die aus Metallpulver und einem Lösungsmittel bestehende Paste vor dem Aufsetzen des Bauelements auf das Substrat getrocknet werden muß, da sonst der Lösungsmitteldampf großflächige Bauelemente abhebt und über ein System von in der Paste entstehenden Kanälen nach außen entweicht. Andererseits führt die vorausgehende Trocknung der Paste zu relativ rauhen Oberflächen im Kontaktierungsbereich, wobei dieser Nachteil jedoch durch eine Erhöhung des mechanischen Druckes beim Drucksintern auf mindestens 900 N/cm² kompensiert werden kann. Überraschenderweise hat sich herausgestellt, daß derart hohe Drücke und auch Drücke die weit darüber liegen selbst beim Drucksintern von in MOS-Technik hergestellten Leistungshalbleitern zu keinen Schädigungen der feinen Strukturen führen.

Gemäß einer bevorzugten Ausgestaltung der Erfindung wird als Metallpulver das Pulver eines Edelmetalles oder einer Edelmetall-Legierung verwendet. Die Verbindungsschichten weisen dann besonders niedrige elektrische Übergangswiderstände auf. Dabei hat es sich als besonders günstig herausgestellt, wenn als Metallpulver Silberpulver oder das Pulver einer Silberlegierung verwendet wird.

Gemäß einer weiteren Ausgestaltung der Erfindung wird beim Drucksintern ein mechanischer Druck von mindestens 1000 N/cm$^2$ ausgeübt. Eine weitere Steigerung der Güte der Verbindung wird erreicht, wenn beim Drucksintern ein mechanischer Druck von mindestens 1500 N/cm$^2$ ausgeübt wird. Es hat sich als vorteilhaft erwiesen, wenn beim Drucksintern ein mechanischer Druck ausgeübt wird, welcher mindestens dem vorgesehenen Betriebsdruck eines druckkontaktierten Bauelements entspricht.

Durch die Verbindung von Bauelement und Substrat bedingte mechanische Spannungen können dadurch weiter reduziert werden, daß das Bauelement und das Substrat vor dem Drucksintern drucklos auf eine unterhalb der Sintertemperatur liegende Temperatur von mindestens 100°C erwärmt werden. Eine beim Betrieb weitgehend spannungsfreie Ausführung wird schließlich dadurch erreicht, daß das Bauelement und das Substrat drucklos auf eine Temperatur erwärmt werden, welche etwa der vorgesehenen Betriebstemperatur eines Bauelements entspricht.

Zur Erzielung einer besonders geringen Wärmebelastung kann das Drucksintern bereits bei einer Sintertemperatur von mindestens 150°C vorgenommen werden. Noch bessere Verbindungen werden jedoch dann erzielt, wenn das Drucksintern bei einer Sintertemperatur zwischen 180°C und 250°C vorgenommen wird. Sintertemperatur von 250°C und weniger sind insbesondere dann besonders günstig, wenn die Bauelemente zur Lebensdauereinstellung mit Elektronen oder Protonen bestrahlt werden, da höhere Temperaturen dem Effekt dieser Bestrahlung wieder entgegenwirken würden.

Gemäß einer weiteren bevorzugten Ausgestaltung des erfindungsgemäßen Verfahrens wird das Drucksintern in einer Presse mit beheizten Stempeln vorgenommen. Die Erwärmung auf Sintertemperatur bei gleichzeitiger Ausübung des erforderlichen mechanischen Druckes gestaltet sich dann besonders einfach, wobei außerdem die Eignung für eine Massenfertigung hervorzuheben ist. Bei Verwendung einer derartigen Presse kann dann beim Drucksintern die Oberseite des Bauelements durch eine verformbare Zwischenlage geschützt werden. Zusätzlich kann dann auch noch beim Drucksintern über der Zwischenlage eine zweite Zwischenlage aus einem harten Werkstoff mit niedriger Wärmeausdehnung angeordnet werden. Diese zweite steife Zwischenlage gewährleistet dann, daß Wärmeausdehnungen des Pressenstempels nicht auf das Bauelement bzw. dessen feine Strukturen übertragen werden.

Versuche haben gezeigt, daß eine weitere erhebliche Steigerung der mechanischen Festigkeit der Verbindung dadurch erreicht werden kann, daß nach dem Drucksintern eine druckloses Nachsintern vorgenommen wird. Durch dieses drucklose Nachsintern, daß auch als Tempern bezeichnet werden kann, können dann auch die Sinterzeiten in der Presse verkürzt und damit bei einer Massenfertigung höhere Taktzeiten erreicht werden. Dabei hat es sich als vorteilhaft herausgestellt, wenn für das Drucksintern Sinterzeiten im Bereich von einer Minute und für das Nachsintern Sinterzeiten im Bereich von mehreren Minuten gewählt werden.

Ein Ausführungsbeispiel der Erfindung ist in der Zeichnung dargestellt und wird im folgenden näher beschrieben. Zur Verdeutlichung des Schichtaufbaus wurden dabei die Schichtstärken einzelner Zwischenschichten abweichend vom übrigen Maßstab stark übertrieben dargestellt.

Es zeigen:

Fig. 1    ein Substrat im Querschnitt,

Fig. 2    einen großflächigen Leistungshalbleiter im Querschnitt,

Fig. 3    den Leistungshalbleiter nach Fig. 2 in der Draufsicht,

Fig. 4    das Auftragen einer Paste auf das Substrat gemäß Fig. 1,

Fig. 5    das Aufsetzen des in den Fig. 2 und 3 dargestellten Leistungshalbleiters auf das Substrat gemäß Fig. 4 und

Fig. 6    die Anordnung nach Fig. 5 beim Drucksintern in einer Presse.

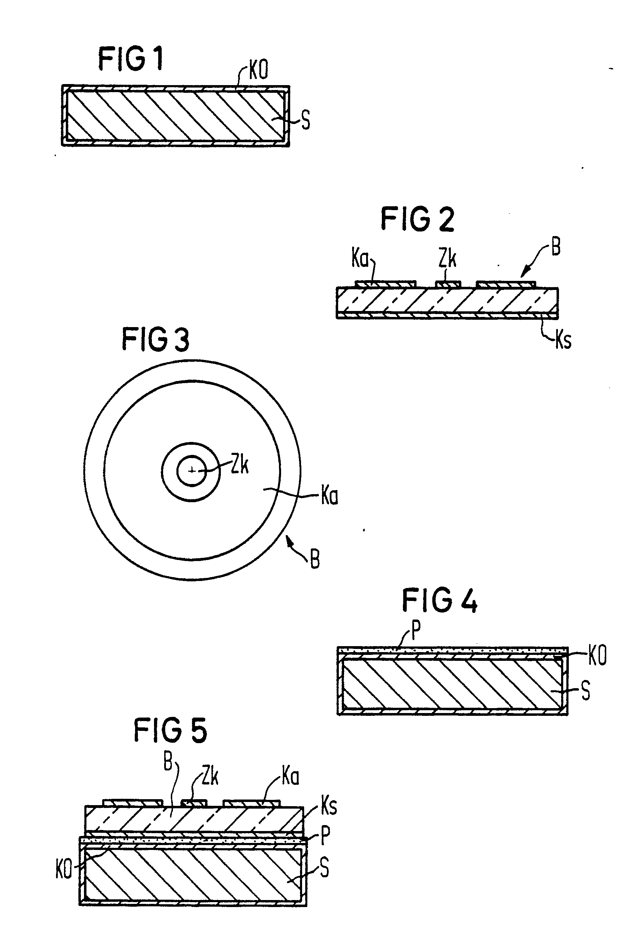

Fig. 1 zeigt einen Schnitt durch ein Substrat S, welches allseitig eine Kontaktoberfläche KO trägt. Bei dem Substrat S handelt es sich beispielsweise um eine 1,5 mm starke Scheibe aus Molybdän mit einem Durchmesser von 29,6 mm. Die galvanisch aufgebrachte Kontaktoberfläche KO ist etwa 2 bis 3 μm stark und besteht aus Silber.

Die Fig. 2 und 3 zeigen ein elektronisches Bauelement B im Querschnitt bzw. in der Draufsicht. Bei diesem Bauelement B handelt es sich um einen großflächigen Thyristor, auf dessen Oberseite als Aluminiumstrukturen ein Zündkontakt Zk und eine Kathode Ka zu erkennen sind. Auf der Unterseite des aus Silizium bestehenden Körpers befindet sich eine Schichtenfolge, welche im einzelnen aus einer ca. 1 μm starken Aluminiumschicht, einer ca. 100 nm starken Titanschicht, einer ca. 500 nm starken Mittelschicht und einer ca. 200 nm starken Silberschicht besteht. In der Zeichnung ist dabei lediglich die als Kontaktierungsschicht Ks dienende Silberschicht zu erkennen.

Gemäß Fig. 4 wird auf die Kontaktoberfläche KO des Substrats S eine Paste P schichtförmig aufgebracht. Das Aufbringen der Paste P in einer Schichtstärke zwischen 10 und 100 $\mu$m, vorzugsweise von ca. 20 $\mu$m, erfolgt durch Siebdrucken. Als Ausgangsstoff für die Herstellung der Paste P wird Silberpulver mit plättchenförmigen Pulverpartikeln, einer Korngröße $\leq$ 15 $\mu$m und einer Schüttdichte von ca. 1,9 g/ml verwendet. Dieses Silberpulver wird dann in Cyclohexanol als Lösungsmittel im Gewichtsverhältnis von etwa 2 : 1 suspendiert. Anschließend wird die derart hergestellte siebdruckfähige Paste P im Vakuum entgast, um später beim Trocknen bzw. Sintern eine Lunkerbildung zu verhindern.

Nach dem Auftragen der Paste P wird diese durch Austreiben des Lösungsmittels vollständig getrocknet. Die Zeit für dieses Trocknen beträgt bei Raumtemperatur ca. 30 Minuten und bei erhöhter Temperatur nur wenige Minuten.

Nach dem Trocknen der Paste P werden das Substrat S und das Bauelement B zusammen oder getrennt auf eine Temperatur erwärmt, die mindestens 100°C beträgt aber noch unterhalb der Sintertemperatur liegt. Dieses druckloses Erwärmen kann auch bereits in einer an späterer Stelle noch zu erläuternden Presse vorgenommen werden.

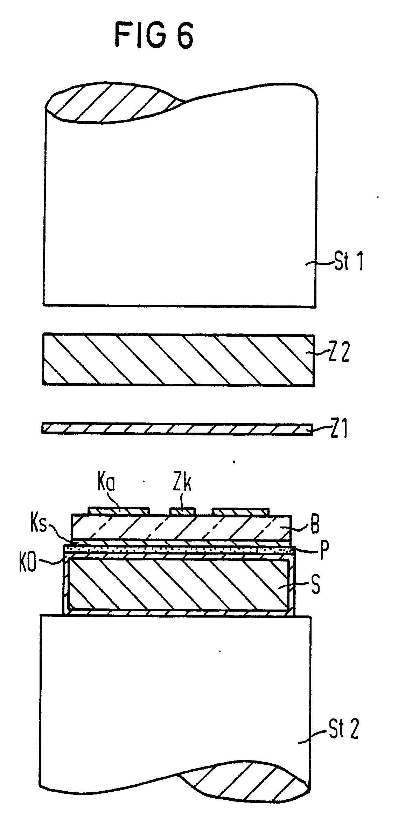

Spätestens nach dem Vorwärmen wird dann das Bauelement B gemäß Fig. 5 mit seiner Kontaktierungsschicht Ks auf die vollständig getrocknete Paste P des Substrats S aufgesetzt. Die gesamte Anordnung wird dann in eine Presse eingebracht, von welcher in Fig. 6 der obere Stempel St1 und der untere Stempel St2 zu erkennen sind. Zwischen der Oberseite des Bauelements B und der Unterseite des oberen Stempels St2 werden nacheinander eine ca. 80 $\mu$m starke erste Zwischenlage Z1 aus Aluminium und eine sehr steife ca. 1,5 mm starke Zwischenlage Z2 aus Molybdän angeordnet, wobei die Anordnung dieser Teile in Fig. 6 zum besseren Erkennen im auseinandergezogenen Zustand dargestellt ist.

Die beiden Stempel St1 und St2 der Presse werden so beheizt, daß in dem dazwischen angeordneten Gebilde die gewünschte Sintertemperatur erreicht wird. Diese Sintertemperatur, die beispielsweise 230°C beträgt, wird dann ca. 1 Minute aufrechterhalten, wobei gleichzeitig über die Stempel St1 und St2 ein mechanischer Druck von 1500 N/cm$^2$ auf die gesamte Anordnung ausgeübt wird. Es ist jedoch ausdrücklich darauf hinzuweisen, daß bereits bei Sinterzeiten von einigen Sekunden gute Ergebnisse erzielt werden können und daß der mechanische Druck gegebenenfalls auch auf 1 - 2 Tonnen pro cm$^2$ gesteigert werden kann. Des weiteren ist hervorzuheben, daß das Drucksintern in normaler Atmosphäre vorgenommen wird, d. h. eine Anwendung von Schutzgas oder Formiergas ist nicht erforderlich.

Nach dem Drucksintern wird die gesamte Anordnung aus der Presse entnommen und zur weiteren Steigerung der mechanischen Festigkeit der Verbindung nachgesintert. Dieses drucklose Nachsintern, das auch als Tempern bezeichnet werden könnte, wird beispielsweise bei einer Temperatur von ca. 250°C vorgenommen, wobei bereits eine Zeitdauer von 5 Minuten zu einer erheblichen Verbesserung der mechanischen Festigkeit führt.

Bei der vorstehend beschriebenen Herstellung einer Thyristors wird die Verbindung von Halbleiterkörper und Substrat durch Drucksintern vorgenommen, wobei der Sintervorgang stets als Festkörperreaktion ohne das Auftreten flüssiger Phasen vor sich gehen soll. Das beschriebene Verfahren ist insbesondere für großflächige und in MOS-Technik hergestellte Leistungshalbleiter geeignet, wobei jedoch auch bei der Herstellung anderer elektronischer Bauelemente erhebliche Vorteile erzielt werden können.

**Ansprüche**

1. Verfahren zur Befestigung von elektronischen Bauelementen, insbesondere von großflächigen Leistungshalbleitern, auf einem Substrat durch Drucksintern, bei welchem man

    a. eine aus Metallpulver und einem Lösungsmittel bestehende Paste (P) schichtförmig auf die Kontaktierungsschicht (Ks) des Bauelements (B) und/oder die Kontaktoberfläche (KO) des Substrats (S) aufträgt,

    b. dann die aufgetragene Paste (P) trocknet,

    c. das Bauelement (B) auf das Substrat (S) aufsetzt und

    d. dann die gesamte Anordnung unter gleichzeitiger Ausübung eines mechanischen Druckes von mindestens 900 N/cm$^2$ auf Sintertemperatur erwärmt.

2. Verfahren nach Anspruch 1, dadurch **gekennzeichnet**, daß als Metallpulver das Pulver eines Edelmetalls oder einer Edelmetall-Legierung verwendet wird.

3. Verfahren nach Anspruch 2, dadurch **gekennzeichnet**, daß als Metallpulver Silberpulver oder das Pulver einer Silberlegierung verwendet wird.

4. Verfahren nach einem der vorhergehenden Ansprüche, dadurch **gekennzeichnet**, daß beim Drucksintern ein mechanischer Druck von mindestens 1000 N/cm$^2$ ausgeübt wird.

5. Verfahren nach einem der Ansprüche 1 bis 3, dadurch **gekennzeichnet**, daß beim Drucksintern ein mechanischer Druck von mindestens 1500 N/cm² ausgeübt wird.

6. Verfahren nach einem der Ansprüche 1 bis 3, dadurch **gekennzeichnet**, daß beim Drucksintern ein mechanischer Druck ausgeübt wird, welcher mindestens dem vorgesehenen Betriebsdruck eines druckkontaktierten Bauelements (B) entspricht.

7. Verfahren nach einem der vorhergehenden Ansprüche, dadurch **gekennzeichnet**, daß das Bauelement (B) und das Substrat (S) vor dem Drucksintern drucklos auf eine unterhalb der Sintertemperatur liegende Temperatur von mindestens 100°C erwärmt werden.

8. Verfahren nach Anspruch 7, dadurch **gekennzeichnet**, daß das Bauelement (B) und das Substrat (S) drucklos auf eine Temperatur erwärmt werden, welche etwa der vorgesehenen Betriebstemperatur eines Bauelements (B) entspricht.

9. Verfahren nach einem der vorhergehenden Ansprüche, dadurch **gekennzeichnet**, daß das Drucksintern bei einer Sintertemperatur von mindestens 150°C vorgenommen wird.

10. Verfahren nach einem der Ansprüche 1 bis 8, dadurch **gekennzeichnet**, daß das Drucksintern bei einer Sintertemperatur zwischen 180°C und 250°C vorgenommen wird.

11. Verfahren nach einem der vorhergehenden Ansprüche, dadurch **gekennzeichnet**, daß das Drucksintern in einer Presse mit beheizten Stempeln (St1, St2) vorgenommen wird.

12. Verfahren nach einem der vorhergehenden Ansprüche, dadurch **gekennzeichnet**, daß beim Drucksintern die Oberseite des Bauelements durch eine verformbare Zwischenlage (Z1) geschützt wird.

13. Verfahren nach Anspruch 12, dadurch **gekennzeichnet**, daß beim Drucksintern über der Zwischenlage (Z1) eine zweite Zwischenlage (Z2) aus einem harten Werkstoff mit niedriger Wärmeausdehnung angeordnet wird.

14. Verfahren nach einem der vorhergehenden Ansprüche, dadurch **gekennzeichnet**, daß nach dem Drucksintern ein druckloses Nachsintern vorgenommen wird.

15. Verfahren nach Anspruch 14, dadurch **ge-**

**kennzeichnet**, daß für das Drucksintern Sinterzeiten im Bereich von einer Minute und für das Nachsintern Sinterzeiten im Bereich von mehreren Minuten gewählt werden.

## Claims

1. Method for mounting electronic components, in particular large-area power semiconductors, on a substrate by pressure sintering, in which
   a. a paste (P) consisting of metal powder and a solvent is applied in a layer onto the contacting layer (KS) of the component (B) and/or the contacting surface (KO) of the substrate (S),
   b. the applied paste (P) is then dried,
   c. the component (B) is placed on the substrate (S)
   and
   d. the entire arrangement is then heated to sintering temperature with simultaneous application of a mechanical pressure of at least 900 N/cm².

2. Method according to Claim 1, characterised in that the powder of a noble metal or of a noble metal alloy is used as the metal powder.

3. Method according to Claim 2, characterised in that silver powder or the powder of a silver alloy is used as the metal powder.

4. Method according to one of the preceding claims, characterised in that when pressure sintering a mechanical pressure of at least 1000 N/cm² is exerted.

5. Method according to one of Claims 1 to 3, characterised in that when pressure sintering a mechanical pressure of at least 1500 N/cm² is exerted.

6. Method according to one of Claims 1 to 3, characterised in that when pressure sintering a mechanical pressure is exerted which corresponds at least to the given operating pressure of a pressure-contacted component (B).

7. Method according to one of the preceding claims, characterised in that before the pressure sintering the component (B) and the substrate (S) are heated in a pressure-free fashion to a temperature which is below the sintering temperature and which is at least 100°C.

8. Method according to Claim 7, characterised in that the component (B) and the substrate (S) are heated in a pressure-free fashion to a temperature which corresponds approximately to the given operating temperature of a component (B).

9. Method according to one of the preceding claims, characterised in that the pressure sintering is performed at a sintering temperature of at least 150°C.

10. Method according to one of Claims 1 to 8, characterised in that the pressure sintering is performed at a sintering temperature between 180°C and 250°C.

11. Method according to one of the preceding claims, characterised in that the pressure sintering is performed in a press with heated punches (St1, St2).

12. Method according to one of the preceding claims, characterised in that when pressure sintering the top of the component is protected by a deformable intermediate layer (Z1).

13. Method according to Claim 12, characterised in that when pressure sintering a second intermediate layer (Z2) consisting of a hard material with a low coefficient of heat expansion is arranged over the intermediate layer (Z1).

14. Method according to one of the preceding claims, characterised in that after pressure sintering a pressure-free resintering is performed.

15. Method according to Claim 14, characterised in that sintering times in the region of one minute are selected for the pressure sintering and sintering times in the region of several minutes are selected for the resintering.

## Revendications

1. Procédé pour fixer des composants électroniques, notamment des semiconducteurs de puissance de surface étendue, sur un substrat par frittage sous pression, et selon lequel
   a. on dépose une pâte (P) constituée par une poudre métallique et un solvant, sous la forme d'une couche sur la couche (KS) d'établissement du contact du composant (B), et/ou sur la surface de contact (KO) du substrat (S),
   b. on fait ensuite sécher la pâte (P) déposée,
   c. on dépose le composant (B) sur le substrat (S), et

d. on chauffe ensuite, à la température de frittage, l'ensemble du dispositif en appliquant simultanément une pression mécanique égale à au moins 900 N/cm².

2. Procédé suivant la revendication 1, caractérisé par le fait qu'on utilise comme poudre métallique la poudre d'un métal précieux ou d'un alliage d'un métal précieux.

3. Procédé suivant la revendication 2, caractérisé par le fait qu'on utilise comme poudre métallique une poudre d'argent ou une poudre d'un alliage d'argent.

4. Procédé suivant l'une des revendications précédentes, caractérisé par le fait que lors du frittage sous pression, on applique une pression mécanique égale à au moins 1000 N/cm².

5. Procédé suivant l'une des revendications 1 à 3, caractérisé par le fait que lors du frittage sous pression, on applique une pression mécanique égale à au moins 1500 N/cm².

6. Procédé suivant l'une des revendications 1 à 3, caractérisé par le fait que lors du frittage sous pression, on applique une pression mécanique qui correspond au moins à la pression de service prévue d'un composant (B) raccordé par contact sous pression.

7. Procédé suivant l'une des revendications précédentes, caractérisé par le fait qu'avant le frittage sous pression, on chauffe le composant (B) et le substrat (S), sans l'application d'une pression, à une température inférieure à la température de frittage et égale à au moins 100°C.

8. Procédé suivant la revendication 7, caractérisé par le fait qu'on chauffe le composant (B) et le substrat (S), sans appliquer une pression, à une température correspondant approximativement à la température de service prévue d'un composant (B).

9. Procédé suivant l'une des revendications précédentes, caractérisé par le fait qu'on réalise le frittage sous pression à une température de frittage égale à au moins 150°C.

10. Procédé suivant l'une des revendications 1 à 8, caractérisé par le fait qu'on réalise le frittage sous pression à une température de frittage comprise entre 180°C et 250°C.

11. Procédé suivant l'une des revendications précédentes, caractérisé par le fait qu'on réalise le frittage sous pression dans une presse, dont les poinçons (St1, St2) sont chauffés.

12. Procédé suivant l'une des revendications précédentes, caractérisé par le fait que lors du frittage sous pression, on protège la surface du composant au moyen d'une couche intercalaire déformable (Z1).

13. Procédé suivant la revendication 12, caractérisé par le fait que lors du frittage sous pression, on dispose au-dessus de la couche intercalaire (Z1) une seconde couche intercalaire (Z2) réalisée en un matériau dur et possédant un coefficient de dilatation thermique faible.

14. Procédé suivant l'une des revendications précédentes, caractérisé par le fait qu'après le frittage sous pression, on exécute un frittage complémentaire sans pression.

15. Procédé suivant la revendication 14, caractérisé par le fait que pour le frittage sous pression, on choisit des durées de frittage de l'ordre d'une minute et pour le frittage complémentaire, on choisit des durées de frittage de l'ordre de plusieurs minutes.

# FIG 1

KO

S

# FIG 2

Ka   Zk   B

Ks

# FIG 3

Zk

Ka

B

# FIG 4

P

KO

S

# FIG 5

B   Zk   Ka

Ks

P

KO

S

# FIG 6

St 1

Z 2

Z 1

Ka  Zk

Ks

KO

B

P

S

St 2